Europäisches Patentamt

European Patent Office

Office européen des brevets

(19)

(11) Veröffentlichungsnummer: **0 085 123**
**B1**

(12) **EUROPÄISCHE PATENTSCHRIFT**

(45) Veröffentlichungstag der Patentschrift:
19.06.85

(51) Int. Cl.⁴: **G 11 C 7/06**

(21) Anmeldenummer: **82100657.4**

(22) Anmeldetag: **30.01.82**

(54) **Integrierte Isolierschicht-Feldeffekttransistor-Schaltung zum Bewerten der Spannung eines Abtastknotens.**

(43) Veröffentlichungstag der Anmeldung:
**10.08.83 Patentblatt 83/32**

(45) Bekanntmachung des Hinweises auf die Patenterteilung:
**19.06.85 Patentblatt 85/25**

(84) Benannte Vertragsstaaten:
**DE FR GB IT NL**

(56) Entgegenhaltungen:
**EP - A - 0 024 001**
**US - A - 3 932 848**
**US - A - 3 946 369**

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Giebel, Burkhard, Dipl.-Ing., Asenweg 15, D-8000 München 83 (DE)**

(74) Vertreter: **Stutzer, Gerhard, Dr., Deutsche ITT Industries GmbH Patent- und Lizenzabteilung Hans-Bunte-Strasse 19 Postfach 840, D-7800 Freiburg (DE)**

BUNDESDRUCKEREI BERLIN

## Beschreibung

Die Erfindung betrifft eine integrierte Isolierschicht-Feldeffekttransistor-Schaltung zum Bewerten der Spannung eines Abtastknotens, wobei der gesteuerte Strompfad eines Transfertransistors zwischen Eingang und Ausgang liegt und der Ausgang über einen als Lastwiderstand geschalteten Transistor und über den gesteuerten Strompfad eines Klemmtransistors, dessen Gate an dem des Transfertransistors liegt, mit der Betriebsspannungsquelle verbunden ist, vergleiche den Oberbegriff des Anspruchs 1.

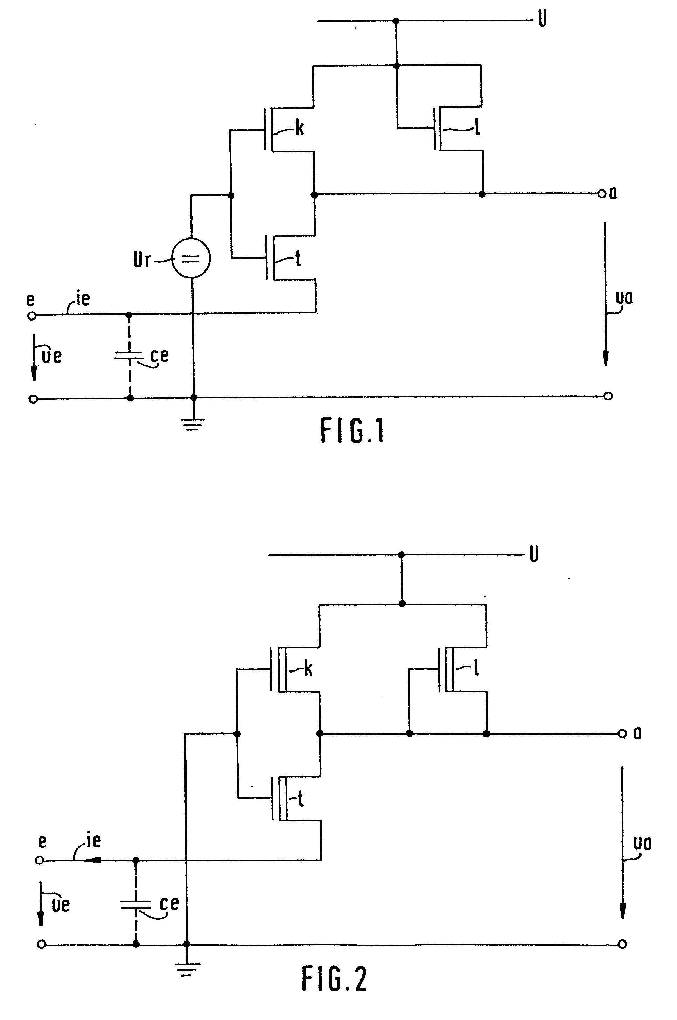

Eine derartige Schaltung, also eine derartige integrierte MOS-Schaltung ist aus der Offenlegungsschrift DE-A-2 932 605 (=EP-A-24 001) in Verbindung mit dem darin genannten Schaltschema des Speicherbausteins 2716 bekannt. Die Fig. 1 dieser Offenlegungsschrift zeigt die Gesamtschaltung einer derartigen MOS-Schaltung, die außer dem Transfertransistor, dort mit M6 bezeichnet, noch zwei am Eingang liegende Inverter enthält wobei der zweite das Gate des Transfertransistors und der erste das Gate eines mit dem Eingang verbundenen Klemmtransistors steuert, dort mit M3 bezeichnet.

Die bekannte Anordnung umfaßt acht MOS-Transistoren und ist daher einigermaßen aufwendig. Der Erfinder vorliegender Anmeldung hat daher in Fig. 2 der genannten Offenlegungsschrift eine einfachere Anordnung angegeben, die nur noch fünf Transistoren enthält. Auch das ist jedoch noch unbefriedigend, so daß der Erfinder an der Reduzierung der Bauelemente weitergearbeitet hat und durch die in den Ansprüchen gekennzeichnete Erfindung, die diese Aufgabe löst, zu einer Anordnung mit nur noch drei MOS-Transistoren gelangt ist.

Somit stellt im Rahmen des vorgesehenen Verwendungszwecks die Erfindung ein Höchstmaß an Schaltungseinfachheit und außerdem an Umempfindlichkeit gegenüber Parameterunterschieden zwischen den Einzeltransistoren der Schaltung dar.

Die Erfindung wird nun an Hand der Figuren der Zeichnung näher erläutert.

Fig. 1 zeigt das Schaltbild eines allgemeinen Ausführungsbeispiels und

Fig. 2 zeigt das Schaltbild eines spezielleren Ausführungsbeispiels.

Im allgemeinen Ausführungsbeispiels der Fig. 1 liegt zwischen dem Eingang e und dem Ausgang a der gesteuerte Strompfad des Transfertransistors t, wie dies auch beim bekannten Stand der Technik der Fall ist. Das Gate dieses Transfertransistors t liegt jedoch im Gegensatz zum bekannten Stand der Technik nicht am Ausgang eines Inverters, sondern entsprechend der Erfindung an der Referenzspannungsquelle Ur.

Der Ausgang a liegt über den als Widerstand geschalteten Lasttransistor l und über den gesteuerten Strompfad des Klemmtransistors k an der Betriebsspannungsquelle U.

In Fig. 1 ist der Lasttransistor l dadurch als Widerstand geschaltet, daß sein Gate an der Betriebsspannungsquelle U liegt, d. h. es ist vorausgesetzt, daß der Lasttransistor l vom Anreicherungstyp ist. Wiederum im Gegensatz zum bekannten Stand der Technik, nach dem das Gate des Klemmtransistors k am Ausgang des genannten Inverters liegt, liegt entsprechend der Erfindung das Gate des Klemmtransistors ebenfalls an der Referenzspannungsquelle Ur, d. h. die Gates von Transfertransistor t und Klemmtransistor k sind zwar wie beim bekannten Stand der Technik miteinander verbunden, jedoch an einen anderen Schaltungspunkt, eben an die Referenzspannungsquelle Ur gelegt.

Beim speziellen Ausführungsbeispiel der Fig. 2 sind die drei Transistoren als solche vom Verarmungstyp vorausgesetzt, so daß das Gate des Lasttransistors l mit dem Ausgang a verbunden ist. Die miteinander verbundenen Gates von Transfer- und Klemmtransistor liegen dagegen am Schaltungsnullpunkt.

Die Schaltung nach der Erfindung hat im wesentlichen zwei Betriebsbereiche:

1. die Eingangsspannung ue ist so niedrig, daß gilt: Ur−ue > ut, (ut = Gateschwellspannung des Transfertransistors t). Unter Vernachlässigung des einen hochohmigen Widerstand darstellenden Lasttransistors l können Transfertransistor t und Klemmtransistor k als ein einziger Transistor aufgefaßt werden, der einen hohen Eingangsstrom erzeugt, so daß bei niedriger Eingangsspannung ue die Schaltung auch einen niedrigen Eingangswiderstand hat. Die Ausgangsspannung ua ist somit nahezu gleich der Eingangsspannung ue.

2. Die Eingangsspannung ue ist so hoch, daß die Beziehung gilt: Ur−ue < ut. Dann sind Transfertransistor t und Klemmtransistor k stromlos und der hochohmige Widerstand des Lasttransistors l bedingt eine hohe Ausgangsspannung ua.

Wichtig ist nun der Übergangsbereich zwischen den eben erläuterten beiden Zuständen. Ist ur−ue nur geringfügig größer als ut, so befindet sich der Transfertransistor t im gesättigten Zustand (ua > ue), und, da der Klemmtransistor k gesperrt ist, ist auch die Ausgangsspannung ua über die Strom-Spannung-Charakteristik des Lasttransistors l nur eine Funktion des Eingangsstroms ie. Die Schaltung ist somit in der Lage, im erwähnten Zustand 1 große parasitäre Kapazitäten ce an einem Abtastknoten rasch aufzuladen und im Übergang zu Zustand 2 kleine Ströme sicher zu erkennen, die in einen Abtastknoten bei nahezu konstantem Abtastknotenpotential fließen.

Bei der bevorzugten Anwendung der Schaltung nach der Erfindung als Leseverstärker von statischen Halbleiter-Speichern, z. B. Festwertspeichern, treten solche parasitären Kapazitäten ce als die der mit dem Abtastknoten verbundenen Bitleitungen auf.

Die Spannung der Referenzspannungsquelle Ur kann konstant oder zeitlich veränderlich sein, und für mehrere Leseverstärker einer integrierten Schaltung kann eine gemeinsame Referenzspannungsquelle vorgesehen werden. Die Referenzspannung kann auf die verschiedensten Arten erzeugt werden, z. B. mittels eines Spannungsteilers, oder sie kann mit der Betriebsspannung identisch sein. Insbesondere kann sie gleich der Spannung des Schaltungsnullpunktes sein, wenn Transfertransistor t und Klemmtransistor k Transistoren vom Verarmungstyp sind, wie dies in Fig. 2 dargestellt ist.

## Patentansprüche

1. Integrierte Isolierschicht-Feldeffekttransistor-Schaltung (MOS-Schaltung) zum Bewerten der Spannung eines Abtastknotens, wobei der gesteuerte Strompfad eines Transfertransistors (t) zwischen Eingang (e) und Ausgang (a) liegt und der Ausgang (a) über einen als Lastwiderstand geschalteten Transistor (l) und über den gesteuerten Strompfad eines Klemmtransistors (k), dessen Gate an dem des Transfertransistors (t) liegt, mit der Betriebsspannungsquelle (U) verbunden ist, dadurch gekennzeichnet, daß die zusammengeschalteten Gates an einer Referenzspannungsquelle (Ur) angeschlossen sind.

2. Schaltung nach Anspruch 1, dadurch gekennzeichnet, daß sie als Leseverstärker in einem statischen Halbleiterspeicher, z. B. einem Festwertspeicher, vorgesehen ist und am selektiv mit den Speicherzellen verbundenen Abtastknoten liegt.

3. Schaltung nach Anspruch 1 oder 2, dadurch gekennzeichnet, daß die drei Transistoren (k, l, t) vom Anreicherungstyp sind.

4. Schaltung nach Anspruch 1 oder 2, dadurch gekennzeichnet, daß der als Lastwiderstand geschaltete Transistor (l) vom Verarmungstyp ist.

5. Schaltung nach einem der Ansprüche 1, 2 oder 4, dadurch gekennzeichnet, daß daß Transfer- und Klemmtransistor (t, k) vom Verarmungstyp sind und daß deren Gate am Schaltungsnullpunkt liegen.

6. Schaltung nach einem der Ansprüche 1 bis 4, dadurch gekennzeichnet, daß die Spannung der Referenzspannungsquelle (Ur) konstant oder zeitlich veränderlich ist und für mehrere Schaltungen einer integrierten Schaltung eine gemeinsame Referenzspannungsquelle vorhanden ist.

7. Schaltung nach Anspruch 6, dadurch gekennzeichnet, daß die Referenzspannungsquelle (Ur) mit der Betriebsspannungsquelle (U) identisch ist.

## Claims

1. Integrated insulated-gate field-effect transistor circuit (MOS circuit) for evaluating the voltage of a node to be sampled, in which the controlled current path of a transfer transistor (t) is arranged between the input (e) and the output (a), and in which said output (a), via a transistor (l) connected as a load resistance, and via the controlled current path of a clamping transistor (k) whose gate is connected to that of said transfer transistor (t), is connected to the source of operating voltage (U), characterized in that said interconnected gates are connected to a source of reference voltage (Ur).

2. A circuit as claimed in claim 1, characterized in that it is intended for use as a sense amplifier in a static semiconductor memory, such as a read-only memory, and is connected to the node to be sampled which is selectively in connection with the memory cells.

3. A circuit as claimed in claims 1 or 2, characterized in that the three transistors (k, l, t) are all of the enhancement type.

4. A circuit as claimed in claims 1 or 2, characterized in that said transistor (l) which is connected as a load resistance, is of the depletion type.

5. A circuit as claimed in any one of claims 1, 2 or 4, characterized in that said transfer transistor and said clamping transistor (t, k) are of the depletion type, and that the gates thereof are connected to the zero point of the circuit.

6. A circuit as claimed in any one of claims 1 to 4, characterized in that the voltage of said source of reference voltage (Ur) is either constant or variable as a function of time, and that for several circuits of a integrated circuit there is provided a common source of reference voltage.

7. A circuit as claimed in claim 6, characterized in that said source of reference voltage (Ur) is identical with said source of operating voltage (U).

## Revendication

1. Circuit intégré à transistor à effet de champ à grille isolée (circuit MOS) pour la mesure de la tension en un noeud de lecture, où le trajet de courant commandé d'un transistor de transfert (t) est disposé entre l'entrée (e) et la sortie (a) et où la sortie (a) est reliée à la source de la tension d'alimentation (U) par un transistor monté en résistance de charge (l) et par le trajet de courant commandé d'un transistor de verrouillage (k) dont la grille est reliée à celle du transistor de transfert t), caractérisé en ce que les grilles reliées entre elles sont reliées à une source de tension de référence (Ur).

2. Circuit selon la revendication 1, caractérisé en ce qu'il est utilisé comme amplificateur de lecture dans une mémoire statique à semiconducteurs, par exemple une mémoire morte, et qu'il est connecté au noeud à lire sélectivement raccordé aux cellules de mémoire.

3. Circuit selon la revendication 1 ou 2, caractérisé en ce que les trois transistors (k, l, t) sont du type à enrichissement.

4. Circuit selon la revendication 1 ou 2, caractérisé en ce que le transistor monté comme résis-

tance de charge (I) est du type à appauvrissement.

5. Circuit selon l'une des revendications 1, 2 ou 4, caractérisè en ce que le transistor de transfert (t) et le transistor de verrouillage (k) sont du type à appauvrissement et en ce que leurs grilles sont reliées au zéro du circuit.

6. Circuit selon l'une des revendications 1 à 4 caractérisé en ce que la tension de la source de tension de référence (Ur) est constante ou variable dans le temps et en ce qu'il existe pour plusieurs circuits d'un circuit intégré une source de tension de référence commune.

7. Circuit selon la revendication 6, caractérisé en ce que la source de tension de référence (Ur) est identique à la source de tension d'alimentation (U).

FIG.1

FIG.2